# EUROPEAN PATENT APPLICATION

(11) **EP 3 868 820 A1**
(43) Date of publication of application: **25.08.2021**
(21) Application number: 20158611.2
(22) Date of filing: 20.02.2020
(51) Int. Cl.: C08K 3/22, C08K 7/28, C08L 81/04, H05K 3/00

(54) **ARTICLES AND STRUCTURES WITH LASER BREAKABLE AND PLATABLE COMPOUNDS**

(71) Applicant: SHPP Global Technologies B.V., 4612 PX Bergen op Zoom (NL)
(72) Inventor: CHENG, Yunan, 2550 Pudong, Shanghai (CN); ZHENG, Yun, 2550 Pudong, Shanghai (CN)
(74) Representative: Dehns

(57) **Abstract**

Disclosed is a composition comprising: from about 10 wt. % to about 90 wt. % of a thermoplastic resin, wherein the thermoplastic resin comprises a polyphenylene sulfide resin; from about 0.01 to 10 wt. % of a laser direct structuring additive; from about 0.01 wt. % to about 50 wt. % of laser breakable filler, wherein the composition exhibits a dissipation factor of less than 0.01 at frequencies of 1 GHz to 20 GHz frequencies when measured using a dielectric resonator, and wherein the combined weight percent value of all components does not exceed 100 wt %, and all weight percent values are based on the total weight of the composition.

## Description

### FIELD OF THE DISCLOSURE

The present disclosure relates to compositions with high laser and plating efficiency, and in particular to polyphenylene sulfide compositions exhibiting high laser and plating efficiency.

### BACKGROUND OF THE DISCLOSURE

With the advent of 5th generation of telecom technology and the application of high frequency millimeter waves, more and more base stations are likely to be constructed. Traditionally, metals comprise the material for construction of base station antennae. Metals, however are generally was heavy, expensive, and large, and have had minimal advances in design over time. There is an overall trend to make the antennas increasingly smaller to match the new frequency, and to assemble a large number of antenna with short cycle time. Laser Direct Structuring (LDS) plastics have thus become favorable in these applications.

Among a wide range of polymers, polyphenylene sulfide PPS exhibits very desirable performance qualities including high flow, high heat, high dimensional stability, high chemical resistance, intrinsically flame retardant and low dissipation factor. These qualities make PPS a suitable base resin for circuitry. There remains a need in the art for a PPS LDS composition because of the undesirable interaction of sulfur with certain LDS additives.

Aspects of the present disclosure addresses these and other needs.

### SUMMARY

Aspects of the disclosure relate to a composition comprising: from about 10 wt. % to about 90 wt. % of a thermoplastic resin, wherein the thermoplastic resin comprises a polyphenylene sulfide resin; from about 0.01 to 10 wt. % of a laser direct structuring additive; from about 0.01 wt. % to about 50 wt. % of laser breakable filler, wherein the composition exhibits a dissipation factor of greater than or equal to 0.005 when observed at 1.9 GHz less than 0.01 at frequencies of 1 GHz to 20 GHz when measured using a dielectric resonator, and wherein the combined weight percent value of all components does not exceed 100 wt %, and all weight percent values are based on the total weight of the composition.

### BRIEF DESCRIPTION OF THE FIGURES

FIG. 1A presents a scanning electron microscopy SEM micrograph of a laser breakable filler prior to laser irradiation.
FIG. 1B presents a scanning electron microscopy SEM micrograph of a laser breakable filler after laser irradiation.
FIG. 2 presents a diagram for modes of plating measurement.
FIG. 3 presents Table 1.2 having the properties of PPS LDS compounds with and without laser breakable glass bead.
FIG. 4 presents Table 2.2 having the properties of PPS LDS compounds with different LDS additives other than tin.
FIG. 5 presents Table 3.2 having the mechanical properties of the polyphenylene LDS compounds in the absence of LDS additives.

### DETAILED DESCRIPTION

With the advent of 5th generation of telecom technology and the application of high frequency millimeter waves, more and more base stations are likely to be constructed. Traditionally, metals comprise the material for construction of base station antennae. Metals, however are generally was heavy, expensive, and large, and have had minimal advances in design over time. There is an overall trend to make the antennas increasingly smaller to match the new frequency, and to assemble a large number of antenna with short cycle time. Laser Direct Structuring (LDS) plastics have thus become favorable in these applications.

Among a wide range of polymers, PPS has high performance include high flow, high heat, high dimensional stability, high chemical resistance, intrinsically flame retardant and low dissipation factor. Thus, the resin is very desirable as a base resin to generate circuit solution. However, there has yet to be a viable PPS LDS solution because sulfur of the PPS may bond with the typical copper LDS in such a strong force that the copper may be deactivated as nuclei seeds for metal plating. The disclosed composition provides compositions including a PPS as base resin with efficient components for laser and copper plating.

Before the present compounds, compositions, articles, systems, devices, and/or methods are disclosed and described, it is to be understood that they are not limited to specific synthetic methods unless otherwise specified, or to particular reagents unless otherwise specified, as such can, of course, vary. It is also to be understood that the terminology used herein is for the purpose of describing particular aspects only and is not intended to be limiting.

Various combinations of elements of this disclosure are encompassed by this disclosure, e.g., combinations of elements from dependent claims that depend upon the same independent claim. Moreover, it is to be understood that unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; and the number or type of embodiments described in the specification.

### Composition

Aspects of the disclosure relate to a composite comprising a thermoplastic polymer component (including a polyphenylene sulfide resin), a laser direct structuring additive, and a laser breakable filler. The novel compositions may include PPS as a base resin and an efficient building block for laser and copper plating. In various aspects, the compositions exhibit a certain dielectric properties. As an example, the composition may exhibit a dissipation factor of less than 0.01 at frequencies of about 1 GHz to about 20 GHz. These compositions may further exhibit desirable plating performance. This is particularly useful for PPS resins that conventionally have poor interaction with LDS additives because of the present sulfur bonding.

A sulfur contained system is indeed to challenge to make effective LDS compounds. Innovatively it is found that combination of laser breakable filler like glass bead and specific type of LDS additive such as tin/antimony oxide work as an effective tool to achieve LDS function in PPS.

### Thermoplastic Resin

In an aspect, the polymer composition may comprise at least a polyarylene sulfide resin. In yet further examples, the thermoplastic resin may comprise polyphenylene sulfide (PPS). The thermoplastic resin may further comprise one or more polymers in addition to the polyarylene sulfide resin, including but not limited to polypropylene, polyethylene, ethylene based copolymer, polyamide, polycarbonate, polyester, polyoxymethylene (POM), polybutylene terephthalate (PBT), polyethylene terephthalate (PET), polycyclohexylendimethylene terephthalate (PCT), liquid crystal polymers (LPC), polyphenylene ether (PPE), polyphenylene oxide-polystyrene blends, polystyrene, high impact modified polystyrene, acrylonitrile-butadiene-styrene (ABS) terpolymer, acrylic polymer, polyetherimide (PEI), polyurethane, polyetheretherketone (PEEK), polylactic acid (PLA) based polymers, poly ether sulphone (PES), and combinations thereof.

The term polyarylene sulfide resin may include polyphenylene sulfide (PPS), polyarylene sulfide ionomers, polyarylene sulfide copolymers, polyarylene sulfide graft copolymers, block copolymers of polyarylene sulfides with alkenyl aromatic compounds or with vinyl aromatic compounds, and combinations comprising at least one of the foregoing polyarylene sulfides. Polyarylene sulfides are known polymers comprising a plurality of structural units of the formula -R-S- wherein R is an aromatic radical such as phenylene, biphenylene, naphthylene, oxydiphenyl, or diphenyl sulfone. Known methods of preparing polyarylene sulfides include those described in U.S. Pat. No. 4,490,522 to Kawabata et al and U.S. Pat. No. 4,837,301 to Glock et al.

In one aspect, the polyarylene sulfide comprises a plurality of structural units of the formula: 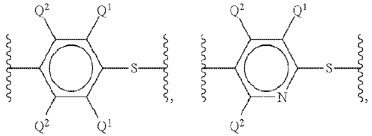 or 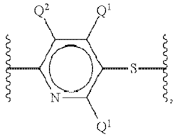 wherein for each structural unit, each Q1 and each Q2 is independently hydrogen, halogen, primary or secondary lower alkyl, phenyl, haloalkyl, aminoalkyl, hydrocarbonoxy, or halohydrocarbonoxy wherein at least two carbon atoms separate the halogen and oxygen atoms. In a further aspect, each Q1 is hydrogen, alkyl, or phenyl. In a further aspect, at least one Q1 is C1-4 alkyl. In a further aspect, each Q2 is hydrogen.

In a further aspect, the polyarylene sulfide comprises a plurality of structural units of the formula: 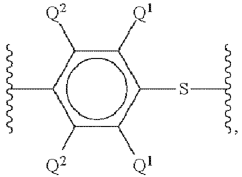 wherein for each structural unit, each Q1 and each Q2 is independently hydrogen, halogen, primary or secondary lower alkyl, phenyl, haloalkyl, aminoalkyl, hydrocarbonoxy, or halohydrocarbonoxy wherein at least two carbon atoms separate the halogen and oxygen atoms. In a further aspect, each Q1 is hydrogen, alkyl, or phenyl. In a further aspect, at least one Q1 is C1-4 alkyl. In a further aspect, each Q2 is hydrogen.

PPS is typically prepared by the reaction of p-dichlorobenzene with sodium sulfide, optionally with the use of a minor proportion of 1,3,5-trichlorobenzene as a branching agent. Reference is made, for example, to U.S. Pat. No. 4,794,163, for a disclosure of typical reagents and conditions employed in polyarylene sulfide preparation. It is often impracticable to determine the molecular weight of a polyarylene sulfide, by reason of its insolubility in essentially all solvents used for molecular weight determination. Indirect characterization of relative molecular weight by melt flow characteristics is commonly employed. The melt flow characteristics of the polyarylene sulfides used according to this invention are not critical; values in the range of 20-1000 g/10 minute (determined at 315° C. under a 5 kg load) are typical.

In various aspects, the polyarylene sulfide is polyphenylene sulfide with a melting temperature of about 270° C. to about 290° C. when determined in accordance with ISO 11357 at 10° C./min and a glass transition temperature of about 80° C. to about 100° C. when determined in accordance with ISO 11357 at 10° C./min. In a still further aspect, the polyarylene sulfide is polyphenylene sulfide with a melting temperature of about 280° C. when determined in accordance with ISO 11357 at 10° C./min and a glass transition temperature of about 90° C. when determined in accordance with ISO 11357 at 10° C./min.

In various further aspects, the polyarylene sulfide is polyphenylene sulfide with a melting temperature of about 270° C. to about 290° C. when determined in accordance with ISO 11357 at 10° C./min; a glass transition temperature of about 80° C. to about 100° C. when determined in accordance with ISO 11357 at 10° C./min; a deflection temperature under load (DTUL) of about 110° C. to about 120° C. under a load of 1.8 MPa when determined in accordance with ISO 75; and a deflection temperature under load (DTUL) of about 90° C. to about 100° C. under a load of 8.0 MPa when determined in accordance with ISO 75. In a still further aspect, the polyarylene sulfide is polyphenylene sulfide with a melting temperature of about 280° C. when determined in accordance with ISO 11357 at 10° C./min; a glass transition temperature of about 90° C. when determined in accordance with ISO 11357 at 10° C./min; a deflection temperature under load (DTUL) of about 115° C. under a load of 1.8 MPa when determined in accordance with ISO 75; and a deflection temperature under load (DTUL) of about 95° C. under a load of 8.0 MPa when determined in accordance with ISO 75.

The thermoplastic resin of the present disclosure may include a polyamide resin, or a combination of polyamide resins. Polyamide resins useful in the practice of the present invention include a generic family of resins referred to as nylons, which may be characterized by the presence of an amide group (-C(O)NH-). Polyamides, including also polyphthalamides (PPA), suitable for use in the present method include but are not limited to polyamide-6, polyamide-6,6, polyamide-4,6, polyamide 9T, polyamide 10T, polyamide-11, polyamide-12, polyamide-6,10, polyamide-6,12, polyamide 6/6,6, polyamide-6/6,12, polyamide MXD6, polyamide-6T, polyamide-6I, polyamide-6/6T, polyamide-6/61, polyamide-6, 6/6T, polyamide-6,6/6I, polyamide- 6/6/1761, polyamide-6,6/6T/6I, polyamide-6/12/6T, polyamide-6,6/12/6T, polyamide-6/12/6I, polyamide-6,6/12/61, and combinations thereof. Nylon-6 and nylon-6,6 represent common polyamides and are available from a variety of commercial sources. Polyamides, however, such as nylon-4,6, nylon-12, nylon-6,10, nylon 6,9, nylon 6/6T and nylon 6,6/6T having triamine contents below about 0.5 wt. %, as well as others, such as amorphous nylons may also be useful. In an example, the polymer composition comprises polyamide-6.

Polycarbonates, and combinations comprising thereof, may also be used as the polymer base resin. As used herein, "polycarbonate" refers to an oligomer or polymer comprising residues of one or more dihydroxy compounds, e.g., dihydroxy aromatic compounds, joined by carbonate linkages; it also encompasses homopolycarbonates, copolycarbonates, and (co)polyester carbonates. The terms "residues" and "structural units", used in reference to the constituents of the polymers, are synonymous throughout the specification. In certain aspects the polycarbonate polymer is a Bisphenol-A polycarbonate, a high molecular weight (Mw) high flow/ductile (HFD) polycarbonate, a low Mw HFD polycarbonate, or a combination thereof.

The terms "BisA," "BPA," or "bisphenol A," which can be used interchangeably, as used herein refers to a compound having a structure represented by formula (1): 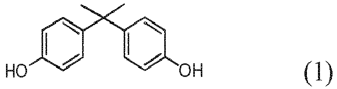 BisA can also be referred to by the name 4,4'-(propane-2,2-diyl)diphenol; p,p'-isopropylidenebisphenol; or 2,2-bis(4-hydroxyphenyl)propane. BisA has the CAS # 80-05-7.

In addition to the polycarbonates described above, combinations of the polycarbonate with other thermoplastic polymers, for example combinations of homopolycarbonates, copolycarbonates, and polycarbonate copolymers with polyesters, can be used. Useful polyesters include, for example, poly(alkylene dicarboxylates), liquid crystalline polyesters, and polyester copolymers. The polyesters described herein can generally be completely miscible with the polycarbonates when blended.

A combination of a first and a second (or more) polycarbonate-polysiloxane copolymers can be used, wherein the average value of E of the first copolymer is less than the average value of E of the second copolymer.

In an aspect, the polydiorganosiloxane blocks are of formula (2) 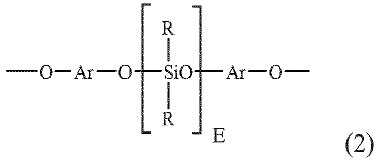 wherein E is as defined above; each R can be the same or different, and is as defined above; and Ar can be the same or different, and is a substituted or unsubstituted C₆-C₃₀ arylene, wherein the bonds are directly connected to an aromatic moiety. Ar groups in formula (2) can be derived from a C₆-C₃₀ dihydroxyarylene compound, for example a dihydroxyarylene compound. Dihydroxyarylene compounds are 1,1-bis(4-hydroxyphenyl) methane, 1,1-bis(4-hydroxyphenyl) ethane, 2,2-bis(4-hydroxyphenyl) propane, 2,2-bis(4-hydroxyphenyl) butane, 2,2-bis(4-hydroxyphenyl) octane, 1,1-bis(4-hydroxyphenyl) propane, 1,1-bis(4-hydroxyphenyl) n-butane, 2,2-bis(4-hydroxy-1-methylphenyl) propane, 1,1-bis(4-hydroxyphenyl) cyclohexane, bis(4-hydroxyphenyl sulfide), and 1,1-bis(4-hydroxy-t-butylphenyl) propane. Combinations comprising at least one of the foregoing dihydroxy compounds can also be used.

In another aspect, polydiorganosiloxane blocks can be of formula (3) 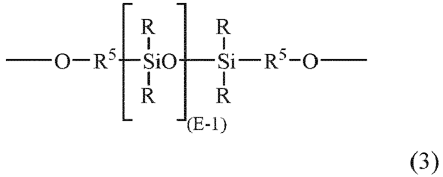 wherein R and E are as described above, and each R⁵ is independently a divalent C₁-C₃₀ organic group, and wherein the polymerized polysiloxane unit is the reaction residue of its corresponding dihydroxy compound. In one aspect, the polydiorganosiloxane blocks are of formula (5): 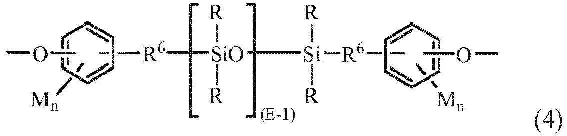 wherein R and E are as defined above. R⁶ in formula (4) is a divalent C₂-C₈ aliphatic. Each M in formula (4) can be the same or different, and can be a halogen, cyano, nitro, C₁-C₈ alkylthio, C₁-C₈ alkyl, C₁-C₈ alkoxy, C₂-C₈ alkenyl, C₂-C₈ alkenyloxy, C₃-C₈ cycloalkyl, C₃-C₈ cycloalkoxy, C₆-C₁₀ aryl, C₆-C₁₀ aryloxy, C₇-C₁₂ aralkyl, C₇-C₁₂ aralkoxy, C₇-C₁₂ alkylaryl, or C₇-C₁₂ alkylaryloxy, wherein each n is independently 0, 1, 2, 3, or 4.

In an aspect, M is bromo or chloro, an alkyl such as methyl, ethyl, or propyl, an alkoxy such as methoxy, ethoxy, or propoxy, or an aryl such as phenyl, chlorophenyl, or tolyl; R⁶ is a dimethylene, trimethylene or tetramethylene; and R is a C₁₋₈ alkyl, haloalkyl such as trifluoropropyl, cyanoalkyl, or aryl such as phenyl, chlorophenyl or tolyl. In another embodiment, R is methyl, or a combination of methyl and trifluoropropyl, or a combination of methyl and phenyl. In still another embodiment, R is methyl, M is methoxy, n is one, R⁶ is a divalent C₁-C₃ aliphatic group. Specific polydiorganosiloxane blocks are of the formula 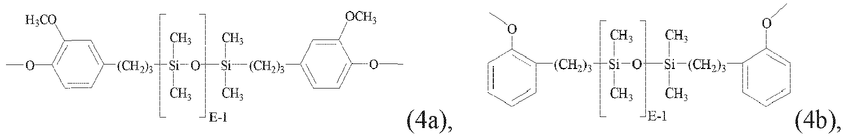 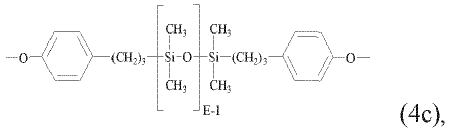 or a combination comprising at least one of the foregoing, wherein E has an average value of 2 to 200, 2 to 125, 5 to 125, 5 to 100, 5 to 50, 20 to 80, or 5 to 20.

Blocks of formula (4) can be derived from the corresponding dihydroxy polydiorganosiloxane, which in turn can be prepared effecting a platinum-catalyzed addition between the siloxane hydride and an aliphatically unsaturated monohydric phenol such as eugenol, 2-alkylphenol, 4-allyl-2-methylphenol, 4-allyl-2-phenylphenol, 4-allyl-2-bromophenol, 4-allyl-2-t-butoxyphenol, 4-phenyl-2-phenylphenol, 2-methyl-4-propylphenol, 2-allyl-4,6-dimethylphenol, 2-allyl-4-bromo-6-methylphenol, 2-allyl-6-methoxy-4-methylphenol and 2-allyl-4,6-dimethylphenol. The polysiloxane-polycarbonate copolymers can then be manufactured, for example, by the synthetic procedure of European Patent Application Publication No. 0 524 731 A1 of Hoover, page 5, Preparation 2.

Transparent polysiloxane-polycarbonate copolymers can comprise carbonate units (1) derived from bisphenol A, and repeating siloxane units or a combination comprising at least one of the foregoing (specifically of formula 4a), wherein E has an average value of 4 to 50, 4 to 15, specifically 5 to 15, more specifically 6 to 15, and still more specifically 7 to 10. The transparent copolymers can be manufactured using one or both of the tube reactor processes described in U.S. Patent Application No. 2004/0039145A1 or the process described in U.S. Patent No. 6,723,864 can be used to synthesize the poly(siloxane-carbonate) copolymers.

The polysiloxane-polycarbonate copolymers can comprise 50 wt. % to 99 wt. % of carbonate units and 1 wt. % to 50 wt. % siloxane units. Within this range, the polyorganosiloxane-polycarbonate copolymer can comprise 70 wt. %, to 98 wt. %, more specifically 75 wt. % to 97 wt. % of carbonate units and 2 wt. % to 30 wt. %, more specifically 3 wt. % to 25 wt. % siloxane units.

In some aspects, a blend can be used, in particular a blend of a bisphenol A homopolycarbonate and a polysiloxane-polycarbonate block copolymer of bisphenol A blocks and eugenol capped polydimethylsilioxane blocks, of the formula (5) 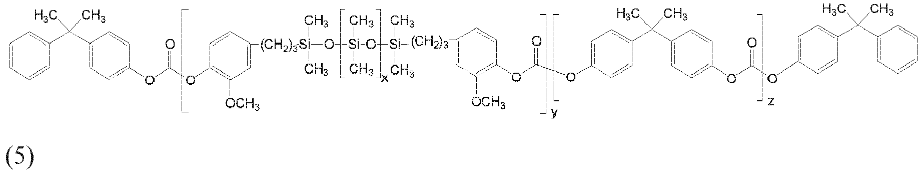 wherein x is 1 to 200, specifically 5 to 85, specifically 10 to 70, specifically 15 to 65, and more specifically 40 to 60; x is 1 to 500, or 10 to 200, and z is 1 to 1000, or 10 to 800. In an embodiment, x is 1 to 200, y is 1 to 90 and z is 1 to 600, and in another embodiment, x is 30 to 50, y is 10 to 30 and z is 45 to 600. The polysiloxane blocks may be randomly distributed or controlled distributed among the polycarbonate blocks.

In one aspect, the polysiloxane-polycarbonate copolymer can comprise 10 wt% or less, specifically 6 wt% or less, and more specifically 4 wt% or less, of the polysiloxane based on the total weight of the polysiloxane-polycarbonate copolymer, and can generally be optically transparent and are commercially available under the designation EXL-T from SABIC. In another aspect, the polysiloxane-polycarbonate copolymer can comprise 10 wt% or more, specifically 12 wt% or more, and more specifically 14 wt% or more, of the polysiloxane copolymer based on the total weight of the polysiloxane-polycarbonate copolymer, are generally optically opaque and are commercially available under the trade designation EXL-P from SABIC.

Polyorganosiloxane-polycarbonates can have a weight average molecular weight of 2,000 Daltons to 100,000 Daltons, specifically 5,000 to 50,000 Daltons as measured by gel permeation chromatography using a crosslinked styrene-divinyl benzene column, at a sample concentration of 1 milligram per milliliter, and as calibrated with polycarbonate standards. The polyorganosiloxane-polycarbonates can have a melt volume flow rate, measured at 300 °C/1.2 kg, of 1 to 50 cubic centimeters per 10 minutes (cm³/10 min), specifically 2 to 30 cm³/10 min. Mixtures of polyorganosiloxane-polycarbonates of different flow properties can be used to achieve the overall desired flow property.

Non-limiting examples of polysiloxane-polycarbonate copolymers can comprise various copolymers available from SABIC. In an aspect, the polysiloxane-polycarbonate copolymer can contain 6 % by weight polysiloxane content based upon the total weight of the polysiloxane-polycarbonate copolymer. In various aspects, the 6 % by weight polysiloxane block copolymer can have a weight average molecular weight (Mw) of from about 23,000 to 24,000 Daltons using gel permeation chromatography with a bisphenol A polycarbonate absolute molecular weight standard. In certain aspects, the 6% weight siloxane polysiloxane-polycarbonate copolymer can have a melt volume flow rate (MVR) of about 10 cm3/ 10 min at 300 °C /1.2 kg (see C9030T, a 6 % by weight polysiloxane content copolymer available from SABIC as "transparent" EXL C9030T resin polymer). In another example, the polysiloxane-polycarbonate block can comprise 20 % by weight polysiloxane based upon the total weight of the polysiloxane block copolymer. For example, an appropriate polysiloxane-polycarbonate copolymer can be a bisphenol A polysiloxane-polycarbonate copolymer endcapped with para-cumyl phenol (PCP) and having a 20 % polysiloxane content (see C9030P, commercially available from SABIC Innovative Plastics as the "opaque" EXL C9030P). In various aspects, the weight average molecular weight of the 20 % polysiloxane block copolymer can be about 29,900 Daltons to about 31,000 Daltons when tested according to a polycarbonate standard using gel permeation chromatography (GPC) on a cross-linked styrene-divinylbenzene column and calibrated to polycarbonate references using a UV-VIS detector set at 264 nm on 1 mg/ml samples eluted at a flow rate of about 1.0 ml/minute. Moreover, the 20% polysiloxane block copolymer can have a melt volume rate (MVR) at 300 °C/1.2 kg of 7 cm³/ 10 min and can exhibit siloxane domains sized in a range of from about 5 micron to about 20 micrometers (microns, µm).

As noted herein, the polymer base resin can comprise a number of thermoplastic resins, or a combination thereof. Certain aspects of the composition include from about 1 wt. % to about 99 wt. % of a thermoplastic resin, or from about 10 wt. % to about 90 wt. % of a thermoplastic resin, or from about 25 wt. % to about 99 wt. % of a thermoplastic resin, or from about 30 wt. % to about 99 wt. % of a thermoplastic resin, or from about 35 wt. % to about 40 wt. % of a thermoplastic resin, or from about 25 wt. % to about 75 wt. % of a thermoplastic resin, or from about 30 wt. % to about 80 wt. % of a thermoplastic resin, or from about 35 wt. % to about 80 wt. % of a thermoplastic resin, or from about 40 wt. % to about 75 wt. % of a thermoplastic resin, or from about 35 wt. % to about 80 wt. % of a thermoplastic resin, or from about 45 wt. % to about 70 wt. % of a thermoplastic resin.

### Laser Direct Structuring Additive

In addition to the thermoplastic resin, the compositions of the present disclosure may comprise a laser direct structuring (LDS) additive. The LDS additive is selected to enable the composition to be used in a laser direct structuring process. In an LDS process, a laser beam exposes the LDS additive to place it at the surface of the thermoplastic composition and to activate metal atoms from the LDS additive. As such, the LDS additive is selected such that, upon exposed to a laser beam, metal atoms are activated and exposed and in areas not exposed by the laser beam, no metal atoms are exposed. In addition, the LDS additive may be selected such that, after being exposed to laser beam, the etching area is capable of being plated to form conductive structure.

As used herein "capable of being plated" refers to a material wherein a substantially uniform metal plating layer can be plated on laser-etched area and show a wide window for laser parameters.

Breaking down copper chromium oxide spinel forms heavy-metal nuclei during activation with the laser during the LDS process. These nuclei enable the material to then be plated by enabling adhesion of the metallization layer in metallization process. Examples of LDS additives that may be useful in the present disclosure include, but are not limited to, a heavy metal mixture oxide spinel, such as copper chromium oxide spinel; a copper salt, such as copper hydroxide phosphate copper phosphate, copper sulfate, cuprous thiocyanate; or a combination including at least one of the foregoing LDS additives.

In one aspect, the LDS additive is a heavy metal mixture oxide spinel, such as copper chromium. The use of the heavy metal mixture oxide spinel enables the composition to be used in a laser direct structuring process while also enhancing the dielectric constant characteristics of the composition such that lower amounts of the ceramic filler are used, thereby improving the reducing the specific gravity of the material and providing a material having a low loss tangent. The laser direct structuring additive may comprise a metal oxide, a copper containing compound, or a combination thereof. In further examples, the laser direct structuring additive comprises tin-antimony oxide (antimony-doped tin oxide), a copper containing compound, or a combination thereof. In yet further aspects, the laser direct structuring additive may comprise tin-antimony oxide, a copper salt, a copper chromium oxide spinel, or a combination thereof. In some examples, the composition is free of or substantially free of a copper salt or a copper chromium oxide spinel, such that the laser direct structuring additive is not a copper salt or a copper chromium oxide spinel.

A particularly useful LDS additive may comprise tin-antimony. Tin-antimony may be present in an amount of 2 wt. % to 8 wt. %, for example, 5 wt. %. In further examples, the LDS additive is present in amounts of from 0.01 wt. % to 30 wt. %. In another example, the LDS additive is present in amounts from 0.01 wt. % to 10 wt. %. In still another embodiment, the LDS additive is present in amounts from 2 wt. % to 8 wt. %.

As discussed, the LDS additive is selected such that, after activating with a laser, the conductive path may be formed by followed a standard electroless plating process. When the LDS additive is exposed to the laser, elemental metal is released. The laser draws the circuit pattern onto the part and leaves behind a roughened surface containing embedded metal particles. These particles act as nuclei for the crystal growth during a subsequent plating process, such as a copper plating process. Other electroless plating processes that may be used include, but are not limited to, gold plating, nickel plating, silver plating, zinc plating, tin plating.

### Laser Breakable Filler

The composition of the present disclosure may comprise a laser breakable filler. In some aspects, the laser breakable filler is hollow. A laser breakable filler may describe a filler having a wall defining an interior. More specifically, the laser breakable filler may comprise a filler having a solid or continuous wall, such as a shell. In further examples the laser breakable filler may comprise a filler having a solid closed wall in that a surface of the filler is free of or substantially free of any gaps or spaces therein.

The wall of the filler may have any suitable thickness. The filler wall may be sufficiently thick to maintain wall integrity about the filler interior. In further aspects, the laser breakable filler has an interior or inner component. The filler interior may be air. In some examples, the filler interior may be a material having a density less than the density of a material forming the filler wall.

A laser breakable filler may describe a filler that can be broken under laser irradiation. The laser breakable filler comprises a filler that maintains structural and physical integrity during processing, but undergoes a physical change when subjected to laser irradiation. As an example, the laser irradiation may be at a wavelength of 1064 nm. An example of laser power may range from 2 Watts (W) to 11W and the laser frequency may range from 40kHZ to 100kHz with a laser scan speed from 2mm/s to 4mm/s.

During processing such as blending and compounding, the filler may remain intact such that the filler wall is solid and remains closed or undisrupted. When subjected to laser irradiation however, the laser breakable filler may undergo a physical change such that the solid, closed wall is opened, broken, or otherwise disrupted and the inner component (or interior) is exposed when observed by SEM.

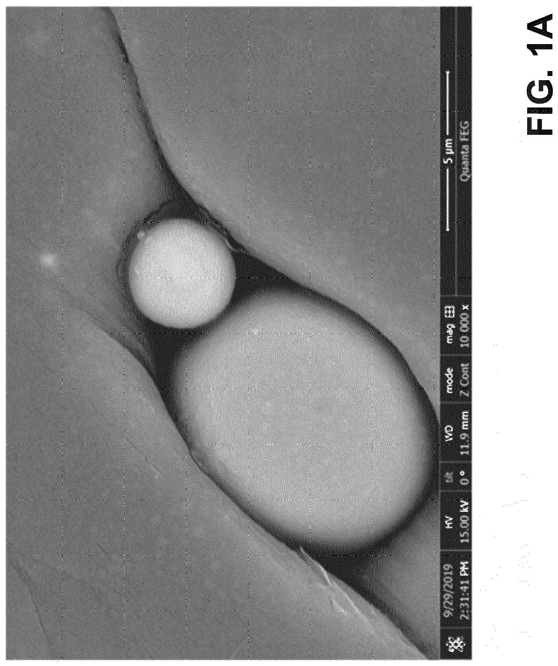

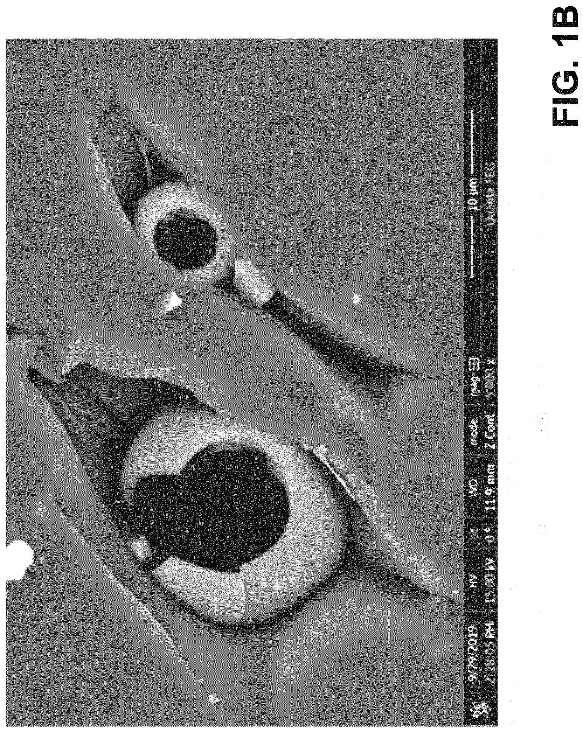

Upon laser irradiation, the wall of the laser breakable filler may be opened, split, or fractured to reveal the interior or inner component. Thus, during a laser platable process a laser breakable filler may be broken. The laser breakable filler may maintain structural and physical integrity during suitable composition processing methods, but may undergo a physical change when subjected to laser irradiation. Breaking of the laser breakable filler may be qualitatively measured and/or observed according to a scanning electron microscope (SEM) micrographs. FIGS. 1A and 1B show a scanning electron micrograph morphology of hollow filler before and after laser breaking, respectively. That is a hollow filler is intact or whole prior to exposure to laser irradiation as in FIG. 1A. FIG. 1B shows the broken laser breakable filler after exposure to laser irradiation.

Suitable laser breakable fillers may include, but are not limited to, hollow ceramics, hollow spheres, hollow glass fiber. As an example, the laser breakable filler may comprise glass hollow filler available from 3M™ as Glass Bubbles S6HS having a 30 micrometer (micron, µm) size, hollow glass bead M18K, or hollow glass bead iM16K.

In some aspects, the composition can comprise from about 0.01 wt. % to about 50 wt. % of a laser breakable filler based on the total weight of the polymer composition. In further aspects the composition may include from about 0.01 wt. % to about 40 wt. %, or from about 0.1 wt. % to about 45 wt. %, or from about 5 wt. % to about 35 wt. %, or from about 10 wt. % to about 40 wt. %, or from about 5 wt. % to about 40 wt. % of a carbon-based filler, or from about 10 wt. % to about 50 wt. % of a carbon-based filler or from about 8 wt. % to about 45 wt. % of a carbon based filler.

### Additives

The disclosed thermoplastic composition can comprise one or more additives conventionally used in the manufacture of molded thermoplastic parts with the proviso that the optional additives do not adversely affect the desired properties of the resulting composition. Mixtures of optional additives can also be used. Such additives can be mixed at a suitable time during the mixing of the components for forming the composite mixture. Exemplary additives can include ultraviolet agents, ultraviolet stabilizers, heat stabilizers, antistatic agents, anti-microbial agents, anti-drip agents, radiation stabilizers, pigments, dyes, fibers, fillers, plasticizers, fibers, flame retardants, antioxidants, lubricants, wood, glass, and metals, and combinations thereof.

According to certain aspects, the polymer compositions may maintain mechanical performance and dielectric strength even with high levels of fillers (for example, greater than 30 wt. % filler based on the total weight of the polymer composition).

The thermoplastic composition disclosed herein can comprise one or more additional fillers. The filler can be selected to impart additional impact strength and/or provide additional characteristics that can be based on the final selected characteristics of the polymer composition. In some aspects, the filler(s) can comprise inorganic materials which can include clay, titanium oxide, asbestos fibers, silicates and silica powders, boron powders, calcium carbonates, talc, kaolin, sulfides, barium compounds, metals and metal oxides, wollastonite, glass spheres, glass fibers, flaked fillers, fibrous fillers, natural fillers and reinforcements, and reinforcing organic fibrous fillers.

Appropriate fillers or reinforcing agents can include, for example, mica, clay, feldspar, quartz, quartzite, perlite, tripoli, diatomaceous earth, aluminum silicate (mullite), synthetic calcium silicate, fused silica, fumed silica, sand, boron-nitride powder, boron-silicate powder, calcium sulfate, calcium carbonates (such as chalk, limestone, marble, and synthetic precipitated calcium carbonates) talc (including fibrous, modular, needle shaped, and lamellar talc), wollastonite, hollow or solid glass spheres, silicate spheres, cenospheres, aluminosilicate or (armospheres), kaolin, whiskers of silicon carbide, alumina, boron carbide, iron, nickel, or copper, continuous and chopped carbon fibers or glass fibers, molybdenum sulfide, zinc sulfide, barium titanate, barium ferrite, barium sulfate, heavy spar, titanium dioxide, aluminum oxide, magnesium oxide, particulate or fibrous aluminum, bronze, zinc, copper, or nickel, glass flakes, flaked silicon carbide, flaked aluminum diboride, flaked aluminum, steel flakes, natural fillers such as wood flour, fibrous cellulose, cotton, sisal, jute, starch , lignin, ground nut shells, or rice grain husks, reinforcing organic fibrous fillers such as poly(ether ketone), polyimide, polybenzoxazole, poly(phenylene sulfide), polyesters, polyethylene, aromatic polyamides, aromatic polyimides, polyetherimides, polytetrafluoroethylene, and poly(vinyl alcohol), as well combinations comprising at least one of the foregoing fillers or reinforcing agents. The fillers and reinforcing agents can be coated or surface treated, with silanes for example, to improve adhesion and dispersion with the polymer matrix. Fillers generally can be used in amounts of 1 to 200 parts by weight, based on 100 parts by weight of based on 100 parts by weight of the total composition.

In various aspects, a reinforcing filler may be present in an amount from about 10 wt. % to about 50 wt. % based on the total weight of the composition. As a specific example, the reinforcing filler may comprise a glass filler, such as a glass fiber, present in an amount from 10 wt. % to about 50 wt. % or from about 10 wt. % to about 30 wt. %. In further examples, the reinforcing filler may comprise glass spheres present in an amount of from about 10 wt. % to about 50 wt. %.

In some aspects, the thermoplastic composition may comprise a synergist. In various examples fillers may serve as flame retardant synergists. The synergist facilitates an improvement in the flame retardant properties when added to the flame retardant composition over a comparative composition that contains all of the same ingredients in the same quantities except for the synergist. Examples of mineral fillers that may serve as synergists are mica, talc, calcium carbonate, dolomite, wollastonite, barium sulfate, silica, kaolin, feldspar, barytes, or the like, or a combination comprising at least one of the foregoing mineral fillers. Metal synergists, e.g., antimony oxide, can also be used with the flame retardant. In one example, the synergist may comprise magnesium hydroxide and phosphoric acid. The mineral filler may have an average particle size of about 0.1 to about 20 micrometers, specifically about 0.5 to about 10 micrometers, and more specifically about 1 to about 3 micrometers.

The thermoplastic composition can comprise an antioxidant. The antioxidants can include either a primary or a secondary antioxidant. For example, antioxidants can include organophosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di-tert-butyl-4-hydroxyhydrocinnamate)] methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate or the like; amides of beta-(3,5-di-tert-butyl-4-hydroxyphenyl)-propionic acid or the like, or combinations including at least one of the foregoing antioxidants. Antioxidants can generally be used in amounts of from 0.01 to 0.5 parts by weight, based on 100 parts by weight of the total composition, excluding any filler.

In various aspects, the thermoplastic composition can comprise a mold release agent. Exemplary mold releasing agents can include for example, metal stearate, stearyl stearate, pentaerythritol tetrastearate, beeswax, montan wax, paraffin wax, or the like, or combinations including at least one of the foregoing mold release agents. Mold releasing agents are generally used in amounts of from about 0.1 to about 1.0 parts by weight, based on 100 parts by weight of the total composition, excluding any filler.

In an aspect, the thermoplastic composition can comprise a heat stabilizer. As an example, heat stabilizers can include, for example, organo phosphites such as triphenyl phosphite, tris-(2,6-dimethylphenyl)phosphite, tris-(mixed mono-and dinonylphenyl)phosphite or the like; phosphonates such as dimethylbenzene phosphonate or the like, phosphates such as trimethyl phosphate, or the like, or combinations including at least one of the foregoing heat stabilizers. Heat stabilizers can generally be used in amounts of from 0.01 to 0.5 parts by weight based on 100 parts by weight of the total composition, excluding any filler.

In further aspects, light stabilizers can be present in the thermoplastic composition. Exemplary light stabilizers can include, for example, benzotriazoles such as 2-(2-hydroxy-5-methylphenyl)benzotriazole, 2-(2-hydroxy-5-tert-octylphenyl)-benzotriazole and 2-hydroxy-4-n-octoxy benzophenone or the like or combinations including at least one of the foregoing light stabilizers. Light stabilizers can generally be used in amounts of from about 0.1 to about 1.0 parts by weight, based on 100 parts by weight of the total composition, excluding any filler.

The thermoplastic composition can also comprise plasticizers. For example, plasticizers can include phthalic acid esters such as dioctyl-4,5-epoxy-hexahydrophthalate, tris-(octoxycarbonylethyl) isocyanurate, tristearin, epoxidized soybean oil or the like, or combinations including at least one of the foregoing plasticizers. Plasticizers are generally used in amounts of from about 0.5 to about 3.0 parts by weight, based on 100 parts by weight of the total composition, excluding any filler.

In yet further aspects, the composition may comprise a pigment or colorant. Suitable colorants may include, but are not limited to, Solvent Green 3, Solvent Green 28, Solvent Green 38, Pigment Green 50, Pigment Green 36, Solvent Red 52, Solvent Red 101, Solvent Red 111, Solvent Red 135, Solvent Red 169, Solvent Red 179, Solvent Red 207, Pigment Red 101, Disperse Red 22, Vat Red 41, Solvent Orange 60, Solvent Orange 63, Disperse Orange 47, Solvent Violet 13, Solvent Violet 14, Solvent Violet 36, Solvent Violet 50, Disperse violet 26/31, Pigment Blue 29, Pigment Blue 60, Copper Phthalocyanine Pigment Blue 15.4, Disperse Blue 73, Solvent Blue 97, Solvent Blue 101, Solvent Blue 104, Solvent Blue 122, Solvent Blue 138, Pigment Yellow 53, Pigment Yellow 138, Pigment Yellow 139, Disperse Yellow 201, Solvent Yellow 33, Solvent Yellow 114, Solvent Yellow 93, Solvent Yellow 98, Solvent Yellow 163, Solvent Yellow 160:1, Solvent Yellow 188, Pigment Brown 24, Amino Ketone Black, chrome oxides, carbon black, channel black, and pigment black 6and the like, as well as combinations including one or more of the foregoing. Any effective amount of the colorant may be included in the molded article. In some aspects the colorant is present in the molded article in an amount of from about 0.00001 to about 0.01 wt. % of the composition, or in certain aspects in an amount of from about 0.00002 to about 0.0010 wt. % of the composition, or even in an amount of from about 0.00002 to about 0.0005 wt. % of the composition.

The thermoplastic composition may comprise a pigment, such as a white pigment. The white pigment can impart the polymer resin composition with opacity or a bright opaque appearance. Examples of white pigments may include titanium dioxide, zinc sulfide (ZnS), tin oxide, aluminum oxide (AlO₃), zinc oxide (ZnO), calcium sulfate, barium sulfate (BaSO₄), calcium carbonate (e.g., chalk), magnesium carbonate, antimony oxide (Sb₂O₃), white lead (a basic lead carbonate, 2PbCO₃·Pb(OH)₂), lithopone (a combination of barium sulfate and zinc sulfide), sodium silicate, aluminum silicate, silicon dioxide (SiO₂, i.e., silica), mica, clay, talc, metal doped versions of the foregoing materials, and combinations including at least one of the foregoing materials. The pigment may be present in an amount of from about 0.1 wt. % to about 50 wt. %. As an example, the composition may include titanium dioxide in an amount of between 0.1 wt. % and 50 wt. %. In a further example, the composition may include titanium dioxide in an amount between 0.1 wt. % and 20 wt. %.

Ultraviolet (UV) absorbers can also be present in the disclosed thermoplastic composition. Exemplary ultraviolet absorbers can include for example, hydroxybenzophenones; hydroxybenzotriazoles; hydroxybenzotriazines; cyanoacrylates; oxanilides; benzoxazinones; 2- (2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]-5-(octyloxy)-phenol (CYASORB™ 1164); 2,2'-(1,4-phenylene)bis(4H-3,1-benzoxazin-4-one) (CYASORB™ UV- 3638); 1,3-bis[(2-cyano-3,3-diphenylacryloyl)oxy]-2,2-bis[[(2-cyano-3, 3-diphenylacryloyl)oxy]methyl]propane (UVINUL™ 3030); 2,2'-(1,4-phenylene)bis(4H-3,1-benzoxazin-4-one); 1,3-bis[(2-cyano-3,3-diphenylacryloyl)oxy]-2,2-bis[[(2-cyano-3,3-diphenylacryloyl)oxy]methyl]propane; nano-size inorganic materials such as titanium oxide, cerium oxide, and zinc oxide, all with particle size less than 100 nanometers; or the like, or combinations including at least one of the foregoing UV absorbers. UV absorbers are generally used in amounts of from 0.01 to 3.0 parts by weight, based on 100 parts by weight of the total composition, excluding any filler.

The thermoplastic composition can further comprise a lubricant. As an example, lubricants can include for example, fatty acid esters such as alkyl stearyl esters, e.g., methyl stearate or the like; mixtures of methyl stearate and hydrophilic and hydrophobic surfactants including polyethylene glycol polymers, polypropylene glycol polymers, and copolymers thereof e.g., methyl stearate and polyethylene-polypropylene glycol copolymers in a suitable solvent; or combinations including at least one of the foregoing lubricants. Lubricants can generally be used in amounts of from about 0.1 to about 5 parts by weight, based on 100 parts by weight of the total composition, excluding any filler.

Anti-drip agents can also be used in the composition, for example a fibril forming or non-fibril forming fluoropolymer such as polytetrafluoroethylene (PTFE). The anti-drip agent can be encapsulated by a rigid copolymer, for example styrene-acrylonitrile copolymer (SAN). PTFE encapsulated in SAN is known as TSAN. In one example, TSAN can comprise 50 wt. % PTFE and 50 wt. % SAN, based on the total weight of the encapsulated fluoropolymer. The SAN can comprise, for example, 75 wt. % styrene and 25 wt. % acrylonitrile based on the total weight of the copolymer. An antidrip agent, such as TSAN, can be used in amounts of 0.1 to 10 parts by weight, based on 100 parts by weight of the total composition, excluding any filler.

As an example, the disclosed composition can comprise an impact modifier. The impact modifier can be a chemically reactive impact modifier. By definition, a chemically reactive impact modifier can have at least one reactive group such that when the impact modifier is added to a polymer composition, the impact properties of the composition (expressed in the values of the IZOD impact) are improved. In some examples, the chemically reactive impact modifier can be an ethylene copolymer with reactive functional groups selected from, but not limited to, anhydride, carboxyl, hydroxyl, and epoxy.

In further aspects of the present disclosure, the composition can comprise a rubbery impact modifier. The rubber impact modifier can be a polymeric material which, at room temperature, is capable of recovering substantially in shape and size after removal of a force. However, the rubbery impact modifier should typically have a glass transition temperature of less than 0° C. In certain aspects, the glass transition temperature (Tg) can be less than -5° C, -10° C, -15° C, with a Tg of less than -30° C typically providing better performance. Representative rubbery impact modifiers can include, for example, functionalized polyolefin ethylene-acrylate terpolymers, such as ethylene-acrylic esters-maleic anhydride (MAH) or glycidyl methacrylate (GMA). The functionalized rubbery polymer can optionally contain repeat units in its backbone which are derived from an anhydride group containing monomer, such as maleic anhydride. In another scenario, the functionalized rubbery polymer can contain anhydride moieties which are grafted onto the polymer in a post polymerization step.

### Properties and Articles

In certain aspects, the disclosed compositions may exhibit a dissipation factor of less than 0.01 or less than 0.007 at frequencies of 1.1 GHz, 1.9 GHz, 5 GHz, 10 GHz, 20 GHz when measured using Agilent Split Post Dielectric Resonator.

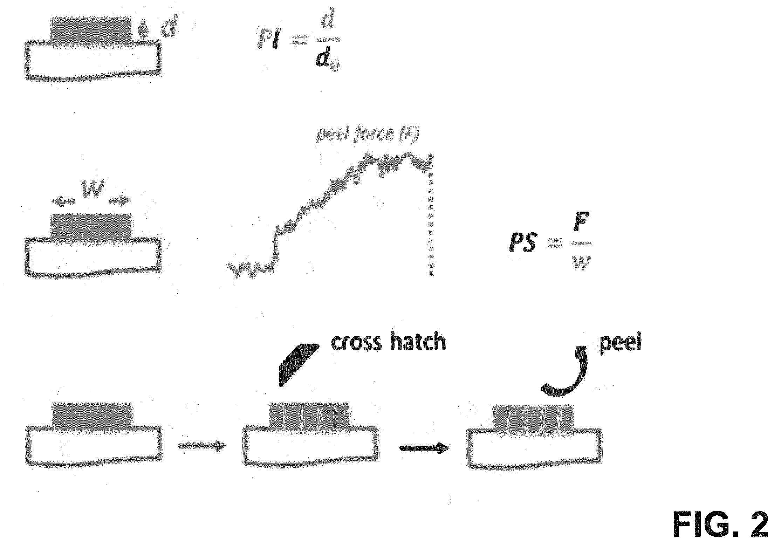

The LDS plating performance may be evaluated according to three different methods: Plating Index (PI), Peel Strength (PS) and cross hatch as shown in FIG. 2. In various aspects, PI was measured by X-ray fluorescence measurement and calculated accordingly. PS test was performed according to an internal method on a Universal Tester, CMT4504, with three procedures: peeling the metal plating from the substrate at starting position, laying the substrate on the platform and fixing planting in proper position by the fixture, peeling strength analyzed by the computer. During the test, parameters were set as: sensor 10kg, distance 25 mm, sample length 70 mm, sample width 3 mm. Once the peel force was obtained by computer, the peel strength was calculated accordingly. Cross hatch was manually cut and taped accordingly.

In various aspects, the present disclosure relates to articles comprising the compositions herein. The compositions can be molded into useful shaped articles by a variety of means such as injection molding, extrusion, rotational molding, blow molding and thermoforming to form articles. The compositions can be useful in the manufacture of articles requiring materials with good flow good impact strength, and good dielectric strength. In various aspects, the compositions may be useful for as well as electrically insulating purposes.

The advantageous characteristics of the compositions disclosed herein can make them appropriate for an array of uses. Formed articles can include, but are not limited to, an antenna, an electrical closure, a lamp housing, or a dielectric film for a capacitor. As a specific example, the disclosed composition may form a telecommunications antenna. An antenna may be formed from a composition comprising: from about 10 wt. % to about 90 wt. % of a thermoplastic resin, wherein the thermoplastic resin comprises a polyphenylene sulfide resin; from about 0.01 to 10 wt. % of a laser direct structuring additive; from about 0.01 wt. % to about 50 wt. % of laser breakable filler, wherein the composition exhibits a dissipation factor at less than 0.01 at frequencies of 1 GHz to 20 GHz when measured using a dielectric resonator, and wherein the combined weight percent value of all components does not exceed 100 wt %, and all weight percent values are based on the total weight of the composition.

### Methods for Making the Composition

Aspects of the disclosure further relate to methods for making a composite including a thermoplastic polymer component. In many aspects, the compositions can be prepared according to a variety of methods. The compositions of the present disclosure can be blended, compounded, or otherwise combined with the aforementioned ingredients by a variety of methods involving intimate admixing of the materials with any additional additives desired in the formulation. Because of the availability of melt blending equipment in commercial polymer processing facilities, melt processing methods can be used. In various further aspects, the equipment used in such melt processing methods can include, but is not limited to, co-rotating and counter-rotating extruders, single screw extruders, co-kneaders, disc-pack processors and various other types of extrusion equipment. In a further aspect, the extruder is a twin-screw extruder. In various further aspects, the composition can be processed in an extruder at temperatures from about 180 °C to about 350 °C, particularly 250 °C to 300 °C.

Methods may further comprise processing the composite to a provide a plaque of a desired thickness. Plaques can be extruded, injection molded, compression molded or injection-compression molded, and may have a thickness between about 0.5 mm and 6 mm. Other processes could also be applied to the thin thermoplastic film, including but not limited to lamination, co-extrusion, thermo-forming or hot pressing. In such aspects, further layers of other materials (for example, other thermoplastic polymer layers, metallic layers, etc.) could be combined with the composite.

Various combinations of elements of this disclosure are encompassed by this disclosure, e.g., combinations of elements from dependent claims that depend upon the same independent claim.

### Definitions

It is also to be understood that the terminology used herein is for the purpose of describing particular aspects only and is not intended to be limiting. As used in the specification and in the claims, the term "comprising" can include the embodiments "consisting of' and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

As used in the specification and the appended claims, the singular forms "a," "an" and "the" include plural referents unless the context clearly dictates otherwise. Thus, for example, reference to "a thermoplastic polymer component" includes mixtures of two or more thermoplastic polymer components. As used herein, the term "combination" is inclusive of blends, mixtures, alloys, reaction products, and the like.

Ranges can be expressed herein as from one value (first value) to another value (second value). When such a range is expressed, the range includes in some aspects one or both of the first value and the second value. Similarly, when values are expressed as approximations, by use of the antecedent 'about,' it will be understood that the particular value forms another aspect. It will be further understood that the endpoints of each of the ranges are significant both in relation to the other endpoint, and independently of the other endpoint. It is also understood that there are a number of values disclosed herein, and that each value is also herein disclosed as "about" that particular value in addition to the value itself. For example, if the value "10" is disclosed, then "about 10" is also disclosed. It is also understood that each unit between two particular units are also disclosed. For example, if 10 and 15 are disclosed, then 11, 12, 13, and 14 are also disclosed.

As used herein, the terms "about" and "at or about" mean that the amount or value in question can be the designated value, approximately the designated value, or about the same as the designated value. It is generally understood, as used herein, that it is the nominal value indicated ±10% variation unless otherwise indicated or inferred. The term is intended to convey that similar values promote equivalent results or effects recited in the claims. That is, it is understood that amounts, sizes, formulations, parameters, and other quantities and characteristics are not and need not be exact, but can be approximate and/or larger or smaller, as desired, reflecting tolerances, conversion factors, rounding off, measurement error and the like, and other factors known to those of skill in the art. In general, an amount, size, formulation, parameter or other quantity or characteristic is "about" or "approximate" whether or not expressly stated to be such. It is understood that where "about" is used before a quantitative value, the parameter also includes the specific quantitative value itself, unless specifically stated otherwise.

As used herein, the terms "optional" or "optionally" means that the subsequently described event or circumstance can or cannot occur, and that the description includes instances where said event or circumstance occurs and instances where it does not. For example, the phrase "optional additional processes" means that the additional processes can or cannot be included and that the description includes methods that both include and that do not include the additional processes.

Disclosed are the components to be used to prepare the compositions of the disclosure as well as the compositions themselves to be used within the methods disclosed herein. These and other materials are disclosed herein, and it is understood that when combinations, subsets, interactions, groups, etc. of these materials are disclosed that while specific reference of each various individual and collective combinations and permutation of these compounds cannot be explicitly disclosed, each is specifically contemplated and described herein. For example, if a particular compound is disclosed and discussed and a number of modifications that can be made to a number of molecules including the compounds are discussed, specifically contemplated is each and every combination and permutation of the compound and the modifications that are possible unless specifically indicated to the contrary. Thus, if a class of molecules A, B, and C are disclosed as well as a class of molecules D, E, and F and an example of a combination molecule, A-D is disclosed, then even if each is not individually recited each is individually and collectively contemplated meaning combinations, A-E, A-F, B-D, B-E, B-F, C-D, C-E, and C-F are considered disclosed. Likewise, any subset or combination of these is also disclosed. Thus, for example, the sub-group of A-E, B-F, and C-E would be considered disclosed. This concept applies to all aspects of this application including, but not limited to, steps in methods of making and using the compositions of the disclosure. Thus, if there are a variety of additional steps that can be performed it is understood that each of these additional steps can be performed with any specific aspect or combination of aspects of the methods of the disclosure.

References in the specification and concluding claims to parts by weight of a particular element or component in a composition or article, denotes the weight relationship between the element or component and any other elements or components in the composition or article for which a part by weight is expressed. Thus, in a compound containing 2 parts by weight of component X and 5 parts by weight component Y, X and Y are present at a weight ratio of 2:5, and are present in such ratio regardless of whether additional components are contained in the compound.

A weight percent of a component, unless specifically stated to the contrary, is based on the total weight of the formulation or composition in which the component is included.

The terms "BisA," "BPA," or "bisphenol A," which can be used interchangeably, as used herein refers to a compound having a structure represented by the formula: 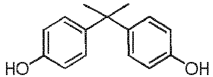 BisA can also be referred to by the name 4,4'-(propane-2,2-diyl)diphenol; p,p'-isopropylidenebisphenol; or 2,2-bis(4-hydroxyphenyl)propane. BisA has the CAS # 80-05-7.

As used herein, "polycarbonate" refers to an oligomer or polymer comprising residues of one or more dihydroxy compounds, e.g., dihydroxy aromatic compounds, joined by carbonate linkages; it also encompasses homopolycarbonates, copolycarbonates, and (co)polyester carbonates.

The terms "residues" and "structural units", used in reference to the constituents of the polymers, are synonymous throughout the specification.

As used herein, dielectric strength may refer to the electrical strength of an insulating material that is, it describes the voltage that an insulating material has the capacity to withstand before breakdown of the material. The dielectric strength may depend on both the thickness of a given material and upon the method and conditions of the test employed to measure the property. The dielectric strength may be determined according to ASTM or ISO standard procedures, for example.

As used herein the terms "weight percent," "wt%," and "wt. %," which can be used interchangeably, indicate the percent by weight of a given component based on the total weight of the composition, unless otherwise specified. That is, unless otherwise specified, all wt% values are based on the total weight of the composition. It should be understood that the sum of wt% values for all components in a disclosed composition or formulation is 100.

Unless otherwise stated to the contrary herein, all test standards are the most recent standard in effect at the time of filing this application.

Each of the materials disclosed herein are either commercially available and/or the methods for the production thereof are known to those of skill in the art.

It is understood that the compositions disclosed herein have certain functions. Disclosed herein are certain structural requirements for performing the disclosed functions and it is understood that there are a variety of structures that can perform the same function that are related to the disclosed structures, and that these structures will typically achieve the same result.

### Aspects of the Disclosure

In various aspects, the present disclosure pertains to and includes at least the following aspects.
Aspect 1. A composition comprising: from about 10 wt. % to about 90 wt. % of a thermoplastic resin, wherein the thermoplastic resin comprises a polyphenylene sulfide resin; from about 0.01 to 10 wt. % of a laser direct structuring additive; from about 0.01 wt. % to about 50 wt. % of laser breakable filler, wherein the composition exhibits a dissipation factor of less than 0.01 at frequencies of 1 GHz to 20 GHz when measured using a dielectric resonator, and wherein the combined weight percent value of all components does not exceed 100 wt %, and all weight percent values are based on the total weight of the composition.
Aspect 2. The composition according to aspect 1, wherein laser breakable filler is hollow.
Aspect 3. The composition of any one of aspects 1-2, wherein the laser breakable filler comprises a filler that maintains structural and physical integrity during processing and undergoes a physical change when subjected to laser irradiation.
Aspect 4. The composition of any one of aspects 1-3, wherein the laser breakable filler has a solid, closed wall that defines an interior, wherein the interior of the laser breakable filler comprises air, a material having a density smaller than that of the solid closed wall, or a combination thereof.
Aspect 5. The composition of aspect 4, wherein the is laser breakable filler undergoes a physical change when subjected to laser irradiation such that the solid, closed wall is open or disrupted and the inner component is exposed when observed by SEM.
Aspect 6. The composition according to any one of aspects 1-5, wherein the laser breakable filler comprises a glass filler.
Aspect 7. The composition according to any one of aspects 1-6, wherein the laser breakable filler comprises a hollow glass sphere.
Aspect 8. The composition according to any one of aspects 1-7, wherein the laser direct structuring additive comprises a metal oxide, a copper containing compound, or a combination thereof.
Aspect 9. The composition according to any one of aspects 1-7, wherein the laser direct structuring additive comprises tin-antimony oxide, a copper containing compound, or a combination thereof.
Aspect 10. The composition according to any one of aspects 1-7, wherein the laser direct structuring additive comprises tin-antimony oxide, a copper salt, a copper chromium oxide spinel, or a combination thereof.
Aspect 11. The composition according to any one of aspects 1-7, wherein the laser direct structuring additive comprises tin-antimony oxide.
Aspect 12. The composition according to any one of aspects 1-8, wherein the laser direct structuring additive is free of or substantially free of a copper salt or a copper chromium oxide spinel.
Aspect 13. The composite of any one of aspects 1-10, further comprising an additive material, the additive material selected from the group consisting of: a reinforcing filler, an antioxidant; a colorant; a de-molding agent; a dye; a flow promoter; a flow modifier; a light stabilizer; a lubricant; a mold release agent; a pigment; a colorant; a quenching agent; a thermal stabilizer; an ultraviolet (UV) absorbant; a UV reflectant; a UV stabilizer; an epoxy chain extender; a flame retardant; and combinations thereof.
Aspect 14. An antenna formed from a composition comprising: from about 10 wt. % to about 90 wt. % of a thermoplastic resin, wherein the thermoplastic resin comprises a polyphenylene sulfide resin; from about 0.01 to 10 wt. % of a laser direct structuring additive; from about 0.01 wt. % to about 50 wt. % of laser breakable filler, wherein the composition exhibits a dissipation factor at less than 0.01 at frequencies of 1 GHz to 20 GHz when measured using a dielectric resonator, and wherein the combined weight percent value of all components does not exceed 100 wt %, and all weight percent values are based on the total weight of the composition.
Aspect 15. The antenna according to aspect 14, wherein laser breakable filler is hollow.
Aspect 16. The antenna of any one of aspects 14-15, wherein the laser breakable filler comprises a filler that maintains structural and physical integrity during processing and undergoes a physical change when subjected to laser irradiation.
Aspect 17. The antenna of any one of aspects 14-16, wherein the laser breakable filler has a solid closed wall that defines an interior, wherein the interior of the laser breakable filler comprises air, a material having a density -smaller than that of the solid closed wall, or a combination thereof.
Aspect 18. The antenna of any one of aspects 14-17, further comprising an additive material, the additive material selected from the group consisting of: an antioxidant; a colorant; a de-molding agent; a dye; a flow promoter; a flow modifier; a light stabilizer; a lubricant; a mold release agent; a pigment; a quenching agent; a thermal stabilizer; an ultraviolet (UV) absorbant; a UV reflectant; a UV stabilizer; an epoxy chain extender; a flame retardant; and combinations thereof.
Aspect 19. The antenna according to any one of aspects 14-18, wherein the laser direct structuring additive is free of or substantially free of a copper salt or a copper chromium oxide spinel.
Aspect 20. The antenna according to any one of aspects 14-18, wherein the laser direct structuring additive comprises a metal oxide.

### EXAMPLES

The following examples are put forth so as to provide those of ordinary skill in the art with a complete disclosure and description of how the compounds, compositions, articles, devices and/or methods claimed herein are made and evaluated, and are intended to be purely exemplary and are not intended to limit the disclosure. Efforts have been made to ensure accuracy with respect to numbers (e.g., amounts, temperature, etc.), but some errors and deviations should be accounted for. Unless indicated otherwise, parts are parts by weight, temperature is in °C or is at ambient temperature, and pressure is at or near atmospheric. Unless indicated otherwise, percentages referring to composition are in terms of wt%. In these examples, the effect of a laser breakable filler, an LDS additive, on the dielectric and physical properties of a PPS composition are examined.

There are numerous variations and combinations of reaction conditions, e.g., component concentrations, desired solvents, solvent mixtures, temperatures, pressures and other reaction ranges and conditions that can be used to optimize the product purity and yield obtained from the described process. Only reasonable and routine experimentation will be required to optimize such process conditions.

The following examples are provided to illustrate the compositions, processes, and properties of the present disclosure. The examples are merely illustrative and are not intended to limit the disclosure to the materials, conditions, or process parameters set forth therein.

### General Materials and Methods

The compositions as set forth in the Examples below were prepared from the components presented in Table 1.1.

**Table 1.1 Formulation of PPS LDS with and without laser breakable glass bead**

| Description | Unit | E1 | C1 | C2 | C3 | C4 |
|---|---|---|---|---|---|---|
| Polyphenylene sulfide PPS (NHU-3418) | % | 54.5 | 64.5 | 59.5 | 59.5 | 54.5 |
| pentaerythritol tetrastearate (PETS) | % | 0.5 | 0.5 | 0.5 | 0.5 | 0.5 |
| flat glass fiber | % | 20 | 30 | 30 | 30 | 30 |
| Hollow glass spheres; 3M™ S60HS, 30 micron | % | 20 | | | | |
| Antimony doped-tin oxide (ATO) | % | 5 | 5 | 10 | 5 | 5 |
| Antimony (III) oxide | % | | | | 5 | 10 |
| Total | % | 100 | 100 | 100 | 100 | 100 |

The disclosed PPS has a density of about 1.35 g/cm³ and is low flow PPS an MFR (ASTM D 1238, 300 °C/2.16 kg) about 50 cm³/10min.

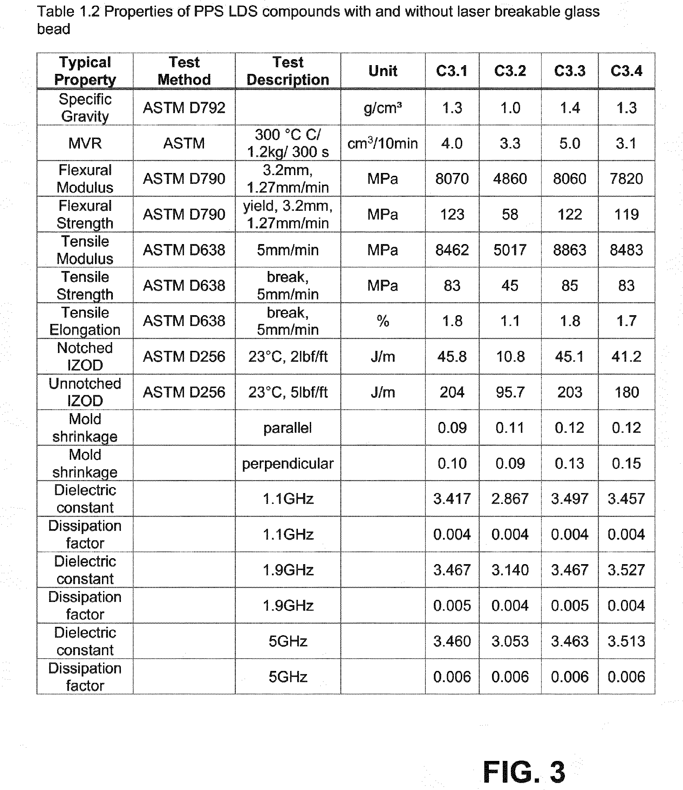

Table 1.2 presents mechanical properties of the polyphenylene LDS compounds and is shown in FIG. 3.

Plating performance (PI and PS) for the samples was also observed according to methods described herein. PI was measured by X-ray fluorescence measurement and calculated accordingly. PS test was performed according to an internal method on a Universal Tester, CMT4504, with three procedures: peeling the metal plating from the substrate at starting position, laying the substrate on the platform and fixing planting in proper position by the fixture, peeling strength analyzed by the computer. During the test, parameters were set as: sensor 10kg, distance 25 mm, sample length 70 mm, sample width 3 mm. Once the peel force was obtained by computer, the peel strength was calculated accordingly. Cross hatch was manually cut and taped accordingly.

According to plating performance observed, a formulation containing laser breakable glass bead (E1) has good LDS function and is successfully plated (indicated by a layer of copper disposed at a surface of the samples), but other formulations without glass bead (C1, C2, C3, C4) could not be plated well (indicated by several plaques of the comparative samples lacking a copper layer disposed thereupon). Additionally, in a system containing only glass fiber and no bead, the negative plating fact is independent on LDS additive type. From C1 to C4, multiple LDS additives and varied loadings were tried but none of them exhibit good plating. Plating plaques of E1 and C1-C3 thus show that inventive sample E1 has much better plating performance in that more plaques have a copper layer successfully disposed thereon.

**Table 2.1 presents formulations for comparative examples having different LDS additives other than tin-antimony, specifically antimony oxide, titanium oxide, and copper chromite.**

| Description | Unit | C2.1 | C2.2 |
|---|---|---|---|
| Polyphenylene sulfide | % | 49.5 | 59.5 |
| PETS | % | 0.5 | 0.5 |
| flat glass fiber | % | 20 | 20 |
| Hollow glass spheres; 3M™ S60HS, 30micron | % | 20 | 20 |
| antimony oxide | % | 5 | |
| titanium oxide | % | 5 | |
| copper chromite | % | | 1 |
| Total | % | 100 | 100 |

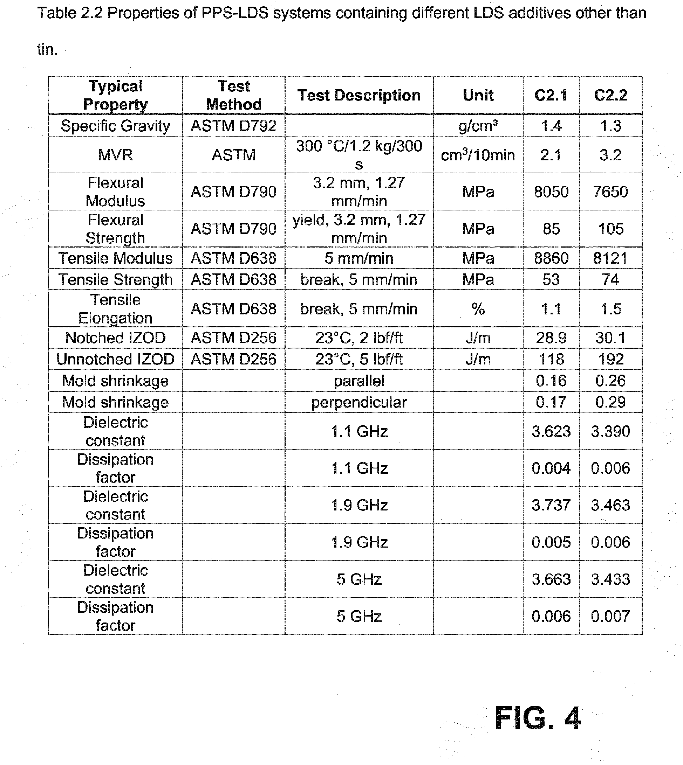

Table 2.2 presents mechanical properties of the polyphenylene LDS compounds having non tin-based LDS additives and is shown in FIG. 4.

Table 2.1 and 2.2 show critical control examples. In a system containing laser breakable glass bead, not all types of LDS additives work. C2.1 containing antimony oxide and titanium oxide or C2.2 containing copper chromite oxide do not work well with LDS function. Plating plaques of C2.1 and C2.2 show that the comparative samples exhibit poor plating performance in that a copper layer is not successfully disposed at the plaque samples.

Table 3.1 presents formulations for comparative examples in the absence of LDS additives.

**Table 3.1 Formulations of laser breakable bead systems without LDS additive.**

| Description | Unit | C3.1 | C3.2 | C3.3 | C3.4 |
|---|---|---|---|---|---|
| Polyphenylene sulfide | % | 59.5 | 59.5 | 59.5 | 59.5 |
| pentaerythritol tetrastearate | % | 0.5 | 0.5 | 0.5 | 0.5 |
| flat glass fiber | % | 20 | - | 20 | 20 |
| 3M S60HS, 30micron | % | 20 | 40 | - | - |
| hollow glass bead M18K | % | - | - | 20 | - |
| hollow glass bead iM16K | % | - | - | - | 20 |
| | % | 100 | 100 | 100 | 100 |

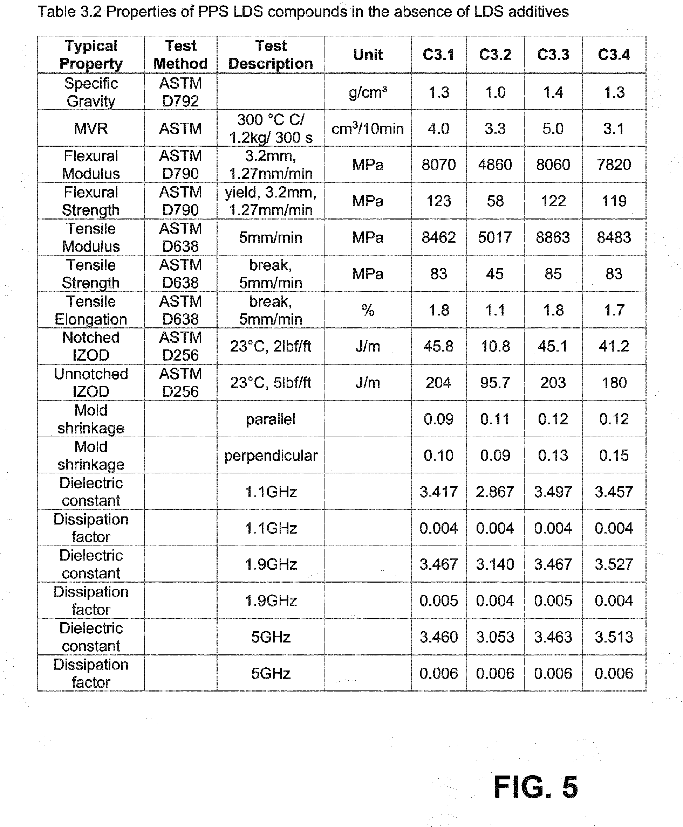

Table 3.2 presents mechanical properties of the polyphenylene LDS compounds in the absence of LDS additives and is shown in FIG. 5. Plating performance (PI and PS) for the samples was also observed according to methods described herein and shows that the LDS additive is still critical to the eventual plating function. See FIG. 2 regarding methods for determining PI and PS. Among the sample systems containing no LDS additives (C3.1 to C3.4), none exhibited good plating performance, although the hollow glass bead type varied. That is, molded plaques of samples C3.1-C3.4 did not show a layer of copper deposited thereon.

Though it is conventionally a challenge to impart plating performance properties to a polymer system containing sulfur (such as polyphenylene sulfide resin), the instant examples combine a breakable filler like glass bead and specific types of LDS additive such as tin/antimony oxide to achieve LDS function in PPS.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the disclosure should be determined with reference to the appended claims, along with the full scope of equivalents to which such claims are entitled.

It will be apparent to those skilled in the art that various modifications and variations can be made in the present disclosure without departing from the scope or spirit of the disclosure. Other embodiments of the disclosure will be apparent to those skilled in the art from consideration of the specification and practice of the disclosure disclosed herein. It is intended that the specification and examples be considered as exemplary only, with a true scope and spirit of the disclosure being indicated by the following claims.

The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A composition comprising:
from about 10 wt. % to about 90 wt. % of a thermoplastic resin, wherein the thermoplastic resin comprises a polyphenylene sulfide resin;
from about 0.01 to 10 wt. % of a laser direct structuring additive;
from about 0.01 wt. % to about 50 wt. % of laser breakable filler,
wherein the composition exhibits a dissipation factor of less than 0.01 at frequencies of 1 GHz to 20 GHz when measured using a dielectric resonator, and
wherein the combined weight percent value of all components does not exceed 100 wt %, and all weight percent values are based on the total weight of the composition.

2. The composition according to claim 1, wherein laser breakable filler is hollow.

3. The composition of any one of claims 1-2, wherein the laser breakable filler comprises a filler that maintains structural and physical integrity during processing and undergoes a physical change when subjected to laser irradiation.

4. The composition of any one of claims 1-3, wherein the laser breakable filler has a solid, closed wall that defines an interior, wherein the interior of the laser breakable filler comprises air, a material having a density less than that of the solid closed wall, or a combination thereof.

5. The composition of claim 4, wherein the is laser breakable filler undergoes a physical change when subjected to laser irradiation such that the solid, closed wall is open or disrupted and the inner component is exposed when observed by SEM.

6. The composition according to any one of claims 1-5, wherein the laser breakable filler comprises a glass filler.

7. The composition according to any one of claims 1-6, wherein the laser breakable filler comprises a hollow glass sphere.

8. The composition according to any one of claims 1-7, wherein the laser direct structuring additive comprises a metal oxide, a copper containing compound, or a combination thereof.

9. The composition according to any one of claims 1-7, wherein the laser direct structuring additive comprises tin-antimony oxide, a copper containing compound, or a combination thereof.

10. The composition according to any one of claims 1-7, wherein the laser direct structuring additive comprises tin-antimony oxide, a copper salt, a copper chromium oxide spinel, or a combination thereof.

11. The composition according to any one of claims 1-7, wherein the laser direct structuring additive comprises tin-antimony oxide.

12. The composition according to any one of claims 1-8, wherein the laser direct structuring additive is free of or substantially free of a copper salt or a copper chromium oxide spinel.

13. The composite of any one of claims 1-10, further comprising an additive material, the additive material selected from the group consisting of: a reinforcing filler, an antioxidant; a colorant; a de-molding agent; a dye; a flow promoter; a flow modifier; a light stabilizer; a lubricant; a mold release agent; a pigment; a colorant; a quenching agent; a thermal stabilizer; an ultraviolet (UV) absorbant; a UV reflectant; a UV stabilizer; an epoxy chain extender; a flame retardant; and combinations thereof.

14. An antenna formed from a composition comprising:
from about 10 wt. % to about 90 wt. % of a thermoplastic resin, wherein the thermoplastic resin comprises a polyphenylene sulfide resin;
from about 0.01 to 10 wt. % of a laser direct structuring additive;
from about 0.01 wt. % to about 50 wt. % of laser breakable filler,
wherein the composition exhibits a dissipation factor at less than 0.01 at frequencies of 1 GHz to 20 GHz when measured using a dielectric resonator, and
wherein the combined weight percent value of all components does not exceed 100 wt %, and all weight percent values are based on the total weight of the composition.

15. The antenna according to claim 14, wherein laser breakable filler is hollow.
